# EUROPÄISCHE PATENTSCHRIFT

(11) **EP 2 406 648 B1**
(45) Veröffentlichungstag und Bekanntmachung des Hinweises auf die Patenterteilung: **30.01.2013**
(21) Anmeldenummer: 10711173.4
(22) Anmeldetag: 05.03.2010
(51) Int. Cl.: G01R 33/09, G01R 33/00

(54) **OBERFLÄCHENMONTIERBARER MAGNETFELDSENSOR MIT EINEM HALBLEITERCHIP UND VERFAHREN ZUR HERSTELLUNG EINER SCHALTUNGSPLATINE MIT EINEM MAGNETFELDSENSOR**
SURFACE-MOUNTABLE MAGNETIC FIELD SENSOR HAVING A SEMICONDUCTOR CHIP AND METHOD FOR PRODUCING A CIRCUIT BOARD HAVING A MAGNETIC FIELD SENSOR
DÉTECTEUR DE CHAMP MAGNÉTIQUE APTE À ÊTRE MONTÉ SUR UNE SURFACE ET DOTÉ D'UNE PUCE SEMICONDUCTRICE, ET PROCÉDÉ DE FABRICATION D'UNE CARTE DE CIRCUIT DOTÉE D'UN DÉTECTEUR DE CHAMP MAGNÉTIQUE

(30) Priorität: 13.03.2009 DE 102009013114
(43) Veröffentlichungstag der Anmeldung: 18.01.2012
(73) Patentinhaber: Conti Temic Microelectronic GmbH, 90411 Nürnberg (DE)
(72) Erfinder: FLOCK, Stefan, 91187 Röttenbach (DE); KRELLA, Uwe, 90443 Nürnberg (DE); STEGER, Jürgen, 91355 Hiltpoltstein (DE)
(74) Vertreter: Bonn, Roman Klemens
(86) Internationale Anmeldenummer: PCT/EP2010/052800
(87) Internationale Veröffentlichungsnummer: WO 2010/102951

(56) Entgegenhaltungen:
- DE-A1- 10 051 472
- US-A1- 2008 030 190

## Beschreibung

Die Erfindung betrifft einen oberflächenmontierbaren Magnetfeldsensor mit einem Halbleiterchip und eine Magnetfeldmessvorrichtung sowie eine Verfahren zur Herstellung und Bestückung einer Schaltungsplatine mit einem Magnetfeldsensor. Der Magnetfeldsensor weist einen Halbleiterchip auf, der auf einem Flachleitersubstrat angeordnet ist. Mindestens drei Flachleiterelektroden, die aus einer Kunststoffgehäuseseite herausragen, stehen mit dem Halbleiterchip elektrisch in Verbindung.

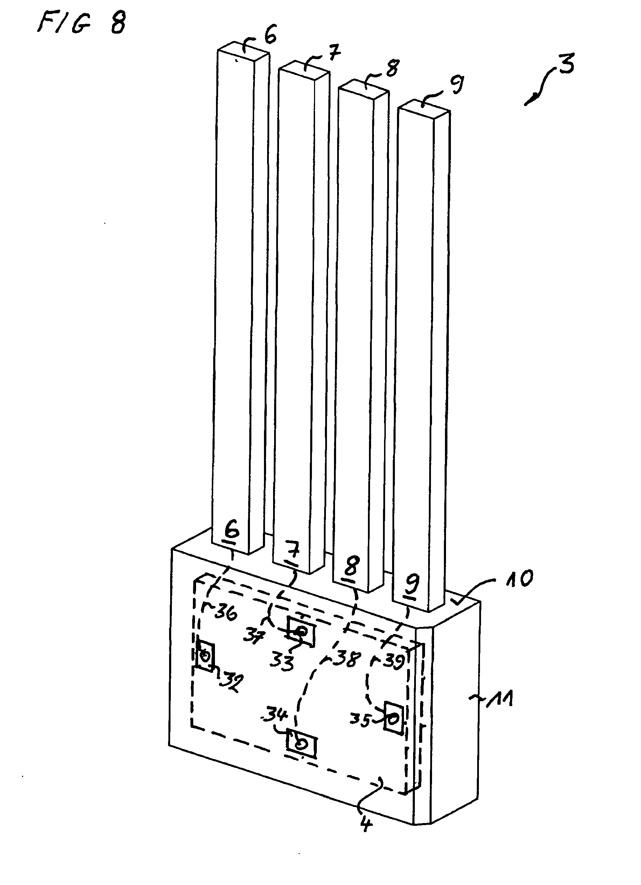

Eine schematische perspektivische Ansicht eines derartigen Magnetfeldsensors 3 zeigt Figur 8. Aus einer Kunststoffgehäuseseite 10 ragen vier Flachleiter 6 bis 9 aus einem Kunststoffgehäuse 11 heraus. In dem Kunststoffgehäuse 11 ist ein Halbleiterchip 4 angeordnet, dessen Lage im Gehäuse 11 mit gestrichelten Linien in Figur 8 gezeigt wird. Auf der Oberseite des Halbleiterchips 4 sind vier Kontaktflecken 32 bis 35 angeordnet, die über entsprechende Verbindungselemente 36 bis 39 innerhalb des Kunststoffgehäuses 11 mit den Flachleiterelektroden 6 bis 9 elektrisch in Verbindung stehen. Wird ein Strom zwischen den Flachleiterelektroden 6 und 9 eingeprägt und das Kunststoffgehäuse 11 mit dem Halbleiterchip 4 in einem Magnetfeldspalt positioniert, so tritt an den Flachleiterelektroden 7 und 8 als Messelektroden eine von der Magnetfeldstärke in dem Magnetfeldspalt und von dem eingeprägten Strom abhängige Messspannung auf.

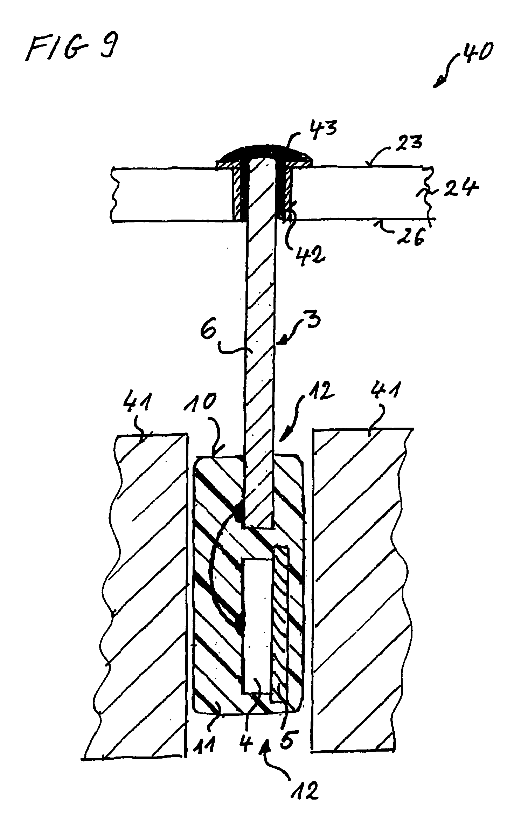

Um von einer Schaltungsplatine aus einen derartigen Magnetfeldsensor 3 in einen Magnetfeldspalt einzubringen, sind in der Schaltungsplatine Durchgangskontaktöffnungen vorzusehen, um die gedruckte Schaltung der Schaltungsplatine mit den vier Flachleiterelektroden elektrisch zu verbinden. Dieses verdeutlicht Figur 9, die einen schematischen Querschnitt durch eine Magnetfeldmessvorrichtung 40 gemäß dem Stand der Technik zeigt. Um beispielsweise den Strom durch eine Zuleitung zu messen, ist diese von einem weichmagnetischen Ring 41 umgeben, der einen Magnetfeldspalt 12 aufweist, in den der Magnetfeldsensor 3 gemäß Figur 9 mit seinem Halbleiterchip 4 und dem Flachleitersubstrat 5, auf dem der Halbleiterchip 4 fixiert ist, eingeschoben ist. Die Schaltungsplatine 24 mit ihrer bestückten Oberseite 23 und ihrer Unterseite 26 weist ein Kontaktloch 42 auf, in das ein Ende 43 der Flachleiterelektrode 6 eingelötet ist. Für ein Einlöten und Fixieren von vier derartigen Flachleiterelektroden 6 bis 9 ist eine manuelle Handhabung notwendig. Dieses erfordert Personalkosten und ist einer automatischen Fertigung nicht zugänglich.

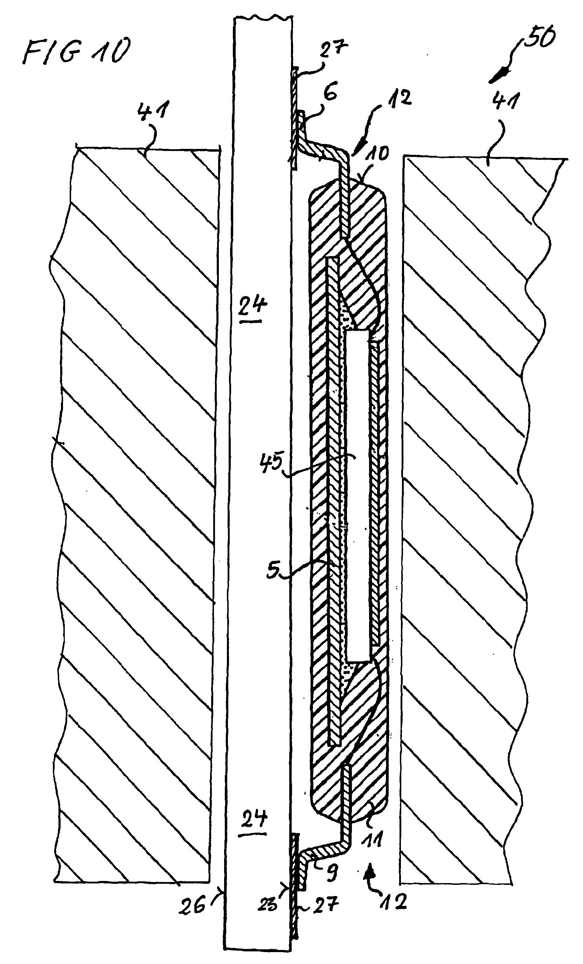

Aus der Druckschrift DE 10 2006 057 970 A1 ist ein Halbleiterbauteil mit einem Magnetfeldsensor bekannt, der auf einer Schaltungsplatine oberflächenmontierbar ist. Eine entsprechende Magnetfeldmessvorrichtung, die mit einem derartigen oberflächenmontierbaren Magnetfeldsensor möglich ist, zeigt Figur 10. Um in diesem Fall die Magnetfeldstärke in einem Magnetfeldspalt 12 zu messen, ist es erforderlich, dass der oberflächenmontierbare Magnetfeldsensor 45 mit der Schaltungsplatine 24 in dem Spalt 12 positioniert wird, mit dem Nachteil, dass dazu ein deutlich breiterer Messspalt in dem weichmagnetischen Ring 41 erforderlich ist. Außerdem wird dann mit dem Magnetfeldspalt 12 die Ausrichtung der Schaltungsplatine 24 vorgegeben, was in vielen Anwendungsfällen ungünstig ist, weshalb die Ausführungsform gemäß Figuren 8 und 9 für Magnetfeldsensoren bevorzugt wird, mit der jedoch eine kostengünstige Oberflächenmontage durch beispielsweise einen automatisch arbeitenden Bestückungsautomaten ausgeschlossen ist. Dies gilt auch für die in US2008/030190 undDE10031472 offenbarten Magnet Feld Seunsoren.

Aufgabe der Erfindung ist es, einen oberflächenmontierbaren Magnetfeldsensor mit einem Halbleiterchip auf einem Flachleitersubstrat und mit mindestens drei Flachleiterelektroden zu schaffen, die aus einer einzigen Kunststoffgehäuseseite herausragen, wobei der Magnetfeldsensor mittels eines Bestückungsautomaten auf einer Schaltungsplatine mit seinen Flachleiterelektroden oberflächenmontierbar sein soll, während der Halbleiterchip beabstandet von der Schaltungsplatine angeordnet ist.

Diese Aufgabe wird mit dem Gegenstand der unabhängigen Ansprüche gelöst. Vorteilhafte Weiterbildungen der Erfindung ergeben sich aus den abhängigen Ansprüchen.

Erfindungsgemäß wird ein oberflächenmontierbarer Magnetfeldsensor mit einem Halbleiterchip und eine Magnetfeldmessvorrichtung geschaffen sowie eine Verfahren zur Herstellung und Bestückung einer Schaltungsplatine offenbart. Der Magnetfeldsensor weist einen Halbleiterchip auf, der auf einem Flachleitersubstrat angeordnet ist. Mindestens drei Flachleiterelektroden, die aus einer einzigen Kunststoffgehäuseseite herausragen, stehen mit dem Halbleiterchip elektrisch in Verbindung. Das Flachleitersubstrat und der Halbleiterchip sind in einem Kunststoffgehäuse eingebettet. Das Kunststoffgehäuse ist mit dem eingebetteten Halbleiterchip in einen Magnetfeldspalt unter Herausragen der Flachleiterelektroden einsetzbar, wobei die Flachleiterelektroden beabstandet von der Kunststoffgehäuseseite Abkantungen aufweisen, die auf einer Schaltungsplatine oberflächenmontierbar sind.

Ein derartiger Magnetfeldsensor hat den Vorteil, dass aufgrund der Abkantungen der Flachleiterelektroden der Magnetfeldsensor unter einem Winkel, vorzugsweise von 90° auf einer Schaltungsplatine oberflächenmontierbar ist, so dass der Halbleiterchip in einen Magnetfeldspalt einführbar ist und die Schaltungsplatine außerhalb des Magnetfeldspalts positioniert werden kann. Darüber hinaus hat ein derartiger Magnetfeldsensor mit abgekanteten Flachleiterelektroden den Vorteil, dass er mittels eines Bestückungsautomaten auf der Schaltungsplatine angeordnet werden kann.

In einer bevorzugten Ausführungsform der Erfindung sind die Abkantungen der Flachleiterelektroden in einem Kunststoffhalter angeordnet. Dieser Kunststoffhalter kann derart an den Flachleiterelektroden fixiert sein, dass die Handhabung des Magnetfeldsensors während der Oberflächenmontage erleichtert wird.

Dabei ragen die Abkantungen in unterschiedlichen Richtungen aus dem Kunststoffhalter heraus, wobei der Kunststoffhalter an den Flachleiterelektroden mittels Heißverstemmen, Ultraschallschweißen oder Klemmen fixiert ist.

Ein vorteilhaftes Merkmal des Halters ist es dabei, dass er einen geglätteten Oberflächenbereich aufweist, welcher die Aufnahme des Bauteils mittels einer Bestückungspipette eines Bestückungsautomaten erlaubt. Das Material des Kunststoffhalters ist vorzugsweise ein Kunststoff, dessen Erweichungsintervall und/oder dessen Zersetzungstemperatur oberhalb der üblichen Löttemperaturen liegt, so dass gewährleistet ist, dass der Kunststoffhalter beim Oberflächenmontieren und Oberflächenlöten auf der Schaltungsplatine nicht beschädigt wird.

In einer weiteren Ausführungsform der Erfindung weist der Kunststoffhalter ein Kodierelement auf. Dieses Kodierelement soll sicherstellen, dass der Kunststoffhalter in korrekter Ausrichtung mit einer Schaltungsplatine oberflächenmotiert werden kann.

Dazu weist der Kunststoffhalter eine seitlich zu dem Oberflächenbereich angebrachte Schürze auf, aus der die Abkantungen der Flachleiterelektroden herausragen, und die einen Wulst als Kodierelement aufweist. Anstelle eines Wulstes können jedoch auch Nuten oder Federn und/oder Aussparungen der seitlichen Schürze des Kunststoffhalters angeordnet sein.

Ferner ist es vorgesehen, dass der Kunststoffhalter mit dem Kodierelement in einer angepassten Öffnung unter einem Winkel zu einer Oberseite der Schaltungsplatine angeordnet ist, wobei das Kunststoffgehäuse unter diesem Winkel von der Oberseite der Schaltungsplatine absteht. Dieser Winkel ist vorzugsweise 90°, so dass das Kunststoffsensorgehäuse in einem Magnetfeldspalt vertikal zur Schaltungsplatine angeordnet werden kann.

Vorzugsweise ist der Magnetfeldsensor ein Hallsensor, der vier Flachleiterelektroden mit Abkantungen aufweist, die jeweils mit einer Randseite der vier Ränder des Hallsensors elektrisch in Verbindung stehen, wie es aus dem Stand der Technik gemäß Figur 8 bekannt ist.

Weiterhin ist es vorgesehen, dass der Kunststoffhalter und das Kunststoffgehäuse eine einstückige Umhüllung der Flachleiterelektroden, des Halbleiterchips und des Flachleitersubstrats aufweisen, wobei aus der einstückigen Umhüllung die Abkantungen der Flachleiterelektroden oberflächenmontierbar herausragen. Bei dieser Ausführungsform des Magnetfeldsensors kann auf einen zu fixierenden Kunststoffhalter verzichtet werden, da die Funktion des Kunststoffhalters nun von dieser Umhüllung, die praktisch ein neues Kunststoffgehäuse für den Magnetfeldsensor bildet, übernommen wird.

Eine Magnetfeldmessvorrichtung mit einem Magnetfeldsensor gemäß dieser Erfindung weist eine mit aktiven und/oder passiven Bauelementen bestückte Seite einer Schaltungsplatine auf, in die eine Öffnung eingearbeitet ist, in der passgenau und ausgerichtet der Magnetfeldsensor mit dem Kunststoffhalter eingesteckt ist. Dabei sind die Abkantungen der Flachleiterelektroden auf der Bestückungsseite oberflächenmontiert und das Kunststoffgehäuse mit dem Halbleiterchip und dem Flachleitersubstrat ragen aus der Unterseite der Schaltungsplatine heraus und in den Magnetfeldspalt hinein. Eine derartige Magnetfeldmessvorrichtung kann kostengünstig hergestellt werden, zumal lediglich ein Abkanten von Flachleiterelektroden eines herkömmlichen Magnetfeldsensors erforderlich ist und mit Hilfe des Kunststoffhalters der Einsatz einer automatischen Bestückungsmaschine gewährleistet werden kann.

Ein Verfahren zur Herstellung und Bestückung einer Schaltungsplatine mit einem Magnetfeldsensor weist die nachfolgenden Verfahrensschritte auf. Zunächst werden Flachleiterelektroden des Magnetfeldsensors, die aus einer Kunststoffgehäuseseite herausragen, abgekantet. Dann wird durch Aufstecken oder Spritzgießen eines Kunststoffhalters auf bzw. an die abgekanteten Flachleiterelektroden ein Magnetfeldsensor geschaffen, der auch von einem Bestückungsautomaten aufgenommen werden kann. Anschließend wird eine Schaltungsplatine hergestellt, die über einem Magnetfeldspalt angeordnet werden kann. In die Schaltungsplatine wird eine Öffnung eingebracht, die in Kontur und Größe einer Schürze mit Kodierelement des Magnetfeldsensors angepasst wird. Schließlich werden auf der Schaltungsplatine Kontaktflächen zur Oberflächenmontage der Abkantungen der Flachleiterelektroden angebracht.

Abschließend wird dann der Magnetfeldsensor in die Öffnung eingebracht und eine Oberflächenmontage des Magnetfeldsensors unter stoffschlüssigem Verbinden der Abkantungen der Flachleiterelektroden auf der Oberseite der Schaltungsplatine durchgeführt, wobei die Kontaktflächen auf der Schaltungsplatine mit den Abkantungen stoffschlüssig verbunden werden. Das Einbringen des Magnetfeldsensors in die Öffnung geschieht derart, dass das Kunststoffgehäuse mit dem Halbleitersensorchip auf der Unterseite des Halbleiterchips beabstandet herausragt. Dieses Verfahren hat den Vorteil, dass es aufgrund des Kunststoffhalters mit einem geglätteten Oberflächenbereich mittels eines Bestückungsautomaten durchgeführt werden kann, zumal nun der Magnetfeldsensor mit Hilfe einer Vakuumpipette in die unterschiedlichen Bearbeitungspositionen eines Bestückungsautomaten verbracht werden kann.

Für ein Einbringen des Magnetfeldsensors in die Öffnungen der Schaltungsplatine unter Einsatz eines Bestückungsautomaten werden mehrere Magnetfeldsensoren auf einem Tablett in Zeilen und Spalten zunächst angeordnet und dann dem Bestückungsautomaten zugeführt. Durch Ansaugen des geglätteten Oberflächenbereichs des Kunststoffhalters mittels einer Vakuumpipette können die Magnetfeldsensoren von dem Tablett abgehoben werden und einer Bestückungsposition auf einer Schaltungsplatine durch den Bestückungsautomaten zugeführt werden. Mit diesem erfindungsgemäßen oberflächenmontierbaren Magnetfeldsensor ergibt sich ein hohes Automatisierungspotential, so dass ein erheblicher Teil der bisherigen Montagekosten eingespart werden kann.

Die Erfindung wird nun anhand der beigefügten Figuren näher erläutert.
- Figur 1: zeigt eine schematische perspektivische Ansicht eines Magnetfeldsensors mit Abkantungen seiner Flachleiterelektroden;
- Figur 2: zeigt eine schematische perspektivische Ansicht des Magnetfeldsensors gemäß Figur 1 nach Anbringen eines Kunststoffhalters für die abgekanteten Flachleiterelektroden gemäß einer ersten Ausführungsform der Erfindung;
- Figur 3: zeigt eine schematische perspektivische Ansicht des Magnetfeldsensors gemäß Figur 2 nach einer Oberflächenmontage des Magnetfeldsensors auf einer Schaltungsplatine;
- Figur 4: zeigt eine schematische perspektivische Ansicht eines Magnetfeldsensors gemäß einer zweiten Ausführungsform der Erfindung;
- Figur 5: zeigt eine schematische perspektivische Ansicht des Magnetfeldsensors gemäß Figur 4 nach einer Oberflächenmontage des Magnetfeldsensors auf einer Schaltungsplatine;
- Figur 6: zeigt eine schematische perspektivische Ansicht einer Magnetfeldmessvorrichtung gemäß der Erfindung mit einem Magnetfeldsensor gemäß Figur 4;
- Figur 7: zeigt eine schematische perspektivische Ansicht eines Tabletts mit positionierten Magnetfeldsensoren gemäß Figur 2 oder Figur 4 zum Zuführen für einen Bestückungsautomaten;
- Figur 8: zeigt eine schematische perspektivische Ansicht eines ersten Magnetfeldsensors gemäß dem Stand der Technik;
- Figur 9: zeigt einen schematischen Querschnitt durch eine Magnetfeldmessvorrichtung gemäß dem Stand der Technik mit einem Magnetfeldsensor gemäß Figur 8;
- Figur 10: zeigt einen schematischen Querschnitt durch eine Magnetfeldmessvorrichtung mit einem oberflächenmontierbaren weiteren Magnetfeldsensor gemäß dem Stand der Technik.

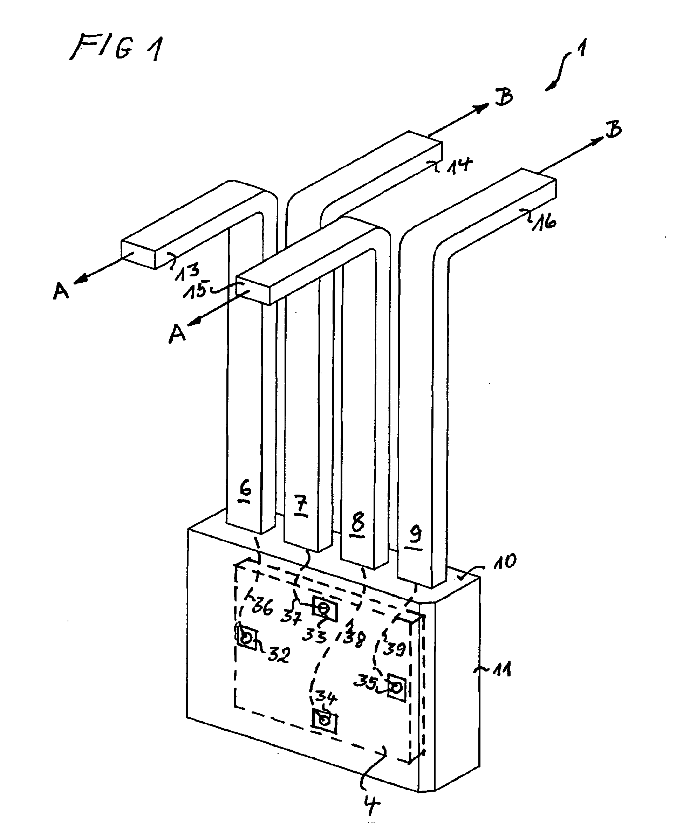

Figur 1 zeigt eine schematische perspektivische Ansicht eines Magnetfeldsensors 1 mit Abkantungen 13 bis 16 seiner Flachleiterelektroden 6 bis 9. Dazu sind die Flachleiterelektroden 6 bis 9 wechselseitig zu entgegen gesetzten Richtungen A und B abgekantet, so dass die Abkantungen 13 und 15 der Flachleiterelektroden 6 und 8 in Pfeilrichtung A abgekantet sind und die Abkantungen 14 und 16 der Flachleiterelektroden 7 und 9 sind in Pfeilrichtung B abgekantet. Diese Abkantungen 13 bis 16 können auf einer Schaltungsplatine oberflächenmontiert werden.

Dazu ist es von Vorteil, wenn eine Vakuumpipette die Abkantungen 13 bis 16 aufnehmen kann. Der Magnetfeldsensor 1 weist wie in Figur 8 einen Halbleiterchip 4 auf, der an seinen Randseiten vier Kontaktflecken 32 bis 35 aufweist, die über Verbindungen 36 bis 39 noch innerhalb eines Kunststoffgehäuses 11 mit den Flachleiterelektroden 6 bis 9 elektrisch verbunden sind. Um eine Flachleitermontage durchzuführen, kann der in Figur 1 gezeigte Magnetfeldsensor mit seinem Halbleiterchip 4 in Form eines Hallgenerators in eine entsprechend große Öffnung einer Schaltungsplatine gehängt werden, wobei Kontaktflächen der bedruckten Schaltung der Schaltungsplatine mit den Abkantungen 13 bis 16 stoffschlüssig verbunden werden können. Diese stoffschlüssige Verbindung kann mittels Löten, Diffusionsschweißen und/oder durch einen Leitkleber erfolgen. Je nach Größe der Flachleiterelektroden 6 bis 9 und der Abkantungen 13 bis 16 ist die Aufnahme des Magnetfeldsensors 1 gemäß Figur 1 durch eine Vakuumpinzette schwierig, zumal die Abkantungen 13 bis 16 weit voneinander beabstandet sind.

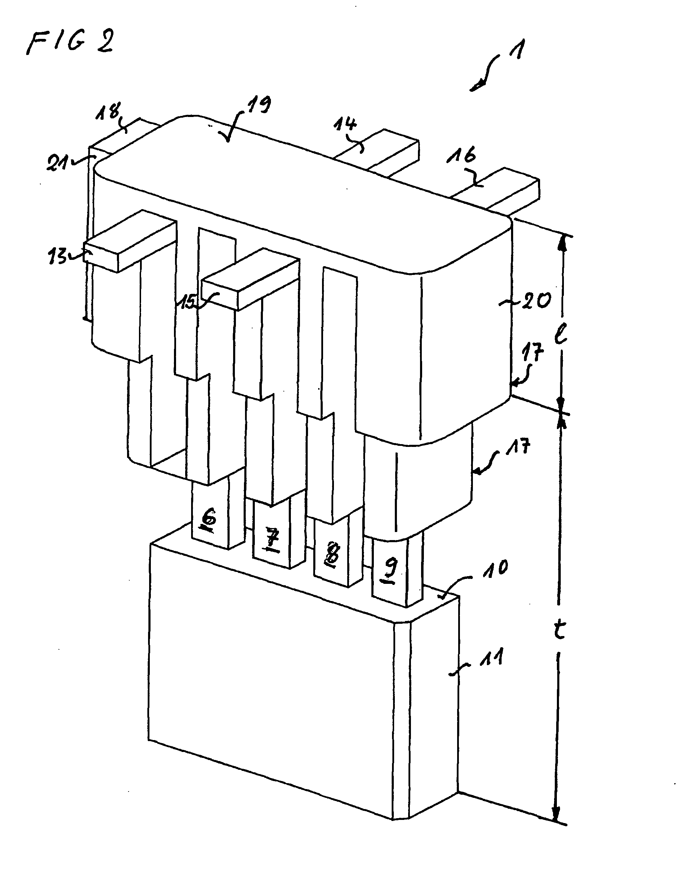

Figur 2 zeigt eine schematische perspektivische Ansicht des Magnetfeldsensors 1 gemäß Figur 1 nach Anbringen eines Kunststoffhalters 17 für die abgekanteten Flachleiterelektroden 6 bis 9 gemäß einer ersten Ausführungsform der Erfindung. Dieser Kunststoffhalter 17 kann auf die Abkantungen 13 bis 16 aufgesteckt, angespritzt, aufgeklebt oder aufgepresst sein. Der Kunststoffhalter 17 weist einen geglätteten Oberflächenbereich 19 auf, auf den eine Vakuumpipette aufgesetzt werden kann, um den Magnetfeldsensor automatisch zu handhaben. Der Oberflächenbereich 19 geht seitlich in eine Schürze 20 über, aus der die Abkantungen 13 bis 16 herausragen. Außerdem weist die Schürze 20 ein Kodierelement 18 auf, das wulstartig auf einer der Seiten der Schürze 20 angeordnet ist. Durch die Länge 1 der Schürze 20 kann die Tiefe t, mit welcher der Magnetfeldsensor 1 in einen Magnetfeldspalt eintauchen soll, vorgegeben werden.

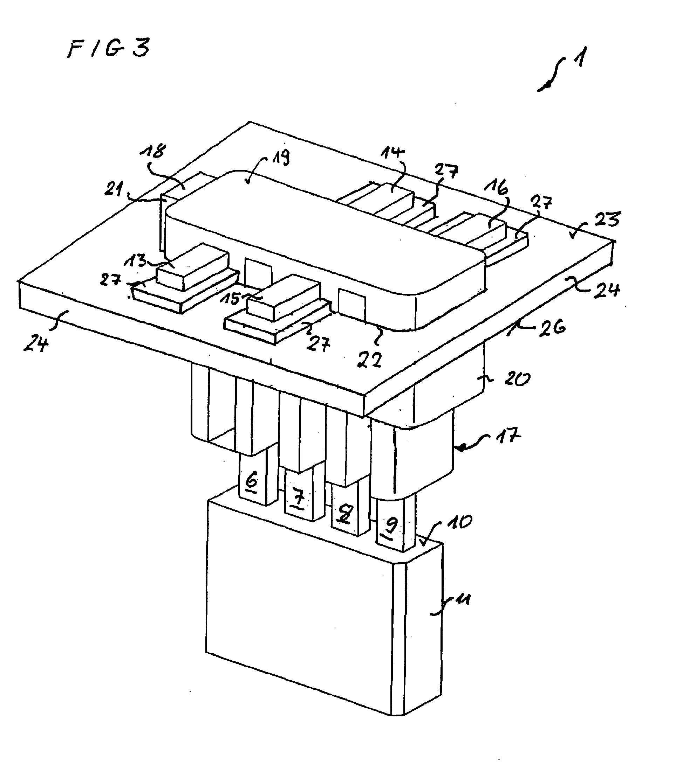

Figur 3 zeigt eine schematische perspektivische Ansicht des Magnetfeldsensors 1 gemäß Figur 2 nach einer Oberflächenmontage des Magnetfeldsensors 1 auf einer Schaltungsplatine 24. Dazu weist die Schaltungsplatine 24 eine Öffnung 22 auf, deren Kontur der Kontur der Schürze 20 mit Kodierelement 18 des Kunststoffhalters 17 angepasst ist. Auf der Oberseite 23 der Schaltungsplatine 24 ist eine Leitungsstruktur aufgebracht, die Kontaktflächen 27 im Bereich der Öffnung 22 aufweist. Diese Kontaktflächen 27 sind entsprechend den Abkantungen 13 bis 16 des Magnetfeldsensors 1 angeordnet, so dass die Abkantungen 13 bis 16 mit den Kontaktflächen 27 stoffschlüssig auf der Oberseite 23 der Schaltungsplatine 24 verbunden werden können.

Für diese stoffschlüssige Verbindung können Leitkleber- oder Lötverfahren eingesetzt werden. Deshalb ist das Material des Kunststoffhalters 17 ein Kunststoff, dessen Erweichungstemperatur bzw. Zersetzungstemperatur höher ist als die Aushärttemperatur eines Klebstoffs bzw. als die Löttemperatur einer Lötverbindung. Durch die Öffnung 22 in der Schaltungsplatine 24 kann der Magnetfeldsensor 1 in die Schaltungsplatine 24 eingesteckt werden, so dass das Gehäuse 11 mit dem Halbleiterchip aus der Unterseite 26 der Schaltungsplatine 24 herausragt und in einem Magnetfeldspalt eingesetzt werden kann.

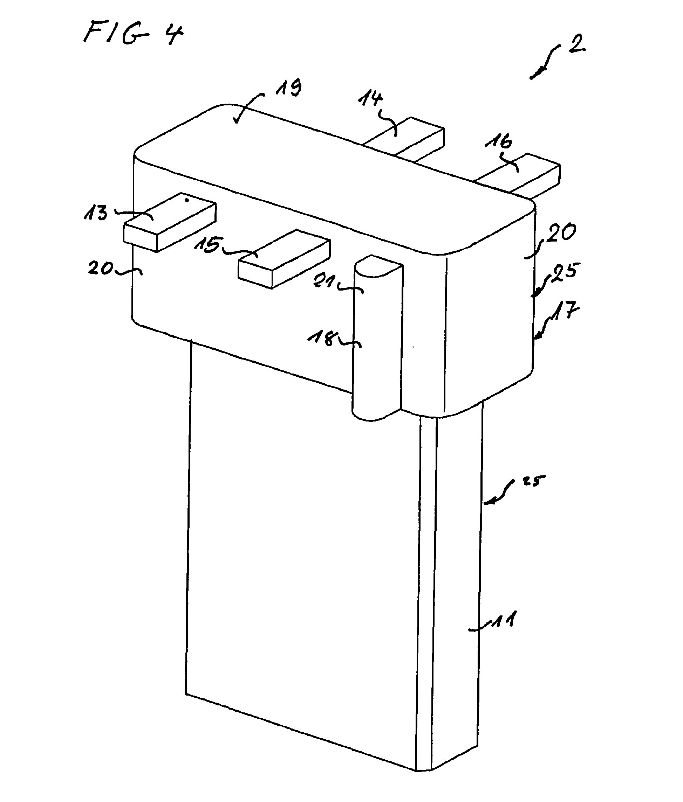

Figur 4 zeigt eine schematische perspektivische Ansicht eines Magnetfeldsensors 2 gemäß einer zweiten Ausführungsform der Erfindung. Komponenten mit gleichen Funktionen wie in den vorhergehenden Figuren werden mit gleichen Bezugszeichen gekennzeichnet und nicht extra erörtert. Bei diesem Magnetfeldsensor 2 weisen der Kunststoffhalter 17 und das Kunststoffgehäuse 11 eine einstückige Umhüllung 25 der Flachleiterelektroden, des Halbleiterchips und des Flachleitersubstrats auf. Somit bildet die einstückige Umhüllung 25, aus der die Abkantungen 13 bis 16 der Flachleiterelektroden herausragen, ein neues Bauteilgehäuse für den Magnetfeldsensor 2 gemäß der zweiten Ausführungsform der Erfindung. Das Kodierelement 18 an der Schürze 20 ist wiederum als Wulst 21 ausgebildet, um eine korrekte Ausrichtung des Magnetfeldsensors 2 in einer Öffnung einer Schaltungsplatine zu gewährleisten.

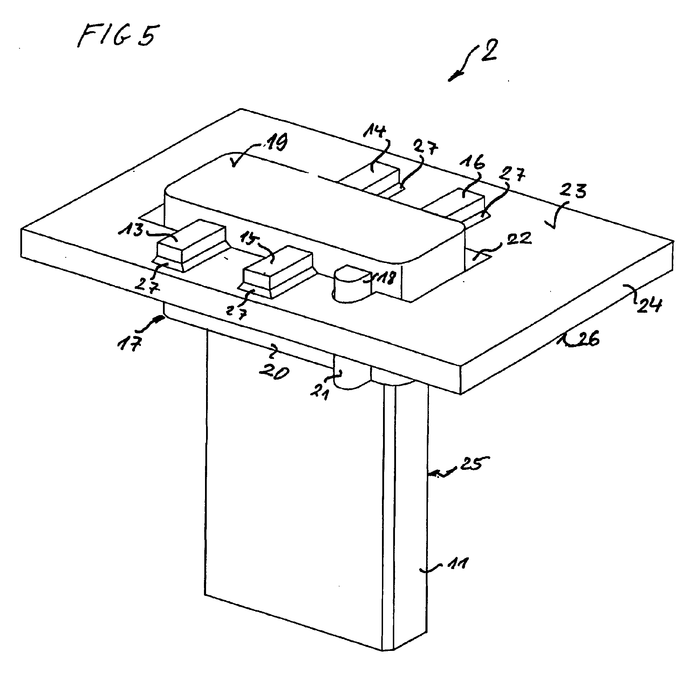

Figur 5 zeigt eine schematische perspektivische Ansicht des Magnetfeldsensors 2 gemäß Figur 4 nach einer Oberflächenmontage des Magnetfeldsensors 2 auf einer Schaltungsplatine 24. Dabei ragt die Umhüllung 25 aus der Unterseite 26 der Schaltungsplatine 24 heraus, während die Abkantungen 13 bis 16 der Flachleiterelektroden auf entsprechende Kontaktflächen 27 im Bereich der Öffnung 22 der Schaltungsplatine 24 oberflächenmontiert sind.

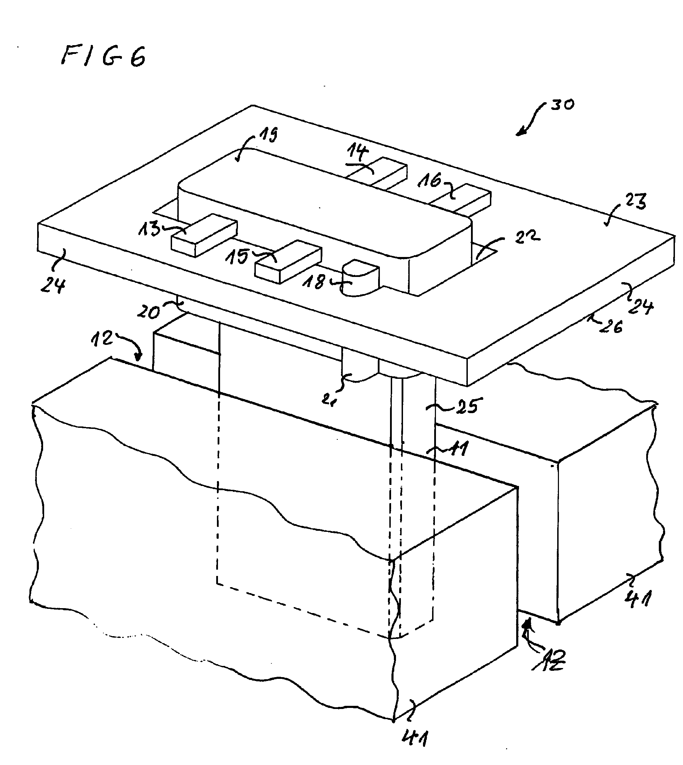

Figur 6 zeigt eine schematische perspektivische Ansicht einer Magnetfeldmessvorrichtung 30 gemäß der Erfindung mit einem Magnetfeldsensor 2 gemäß Figur 4. Bei dieser Magnetfeldmessvorrichtung 30 wird der Magnetfeldsensor 2 mit der Umhüllung 25 in einen Magnetfeldspalt 12 eines weichmagnetischen Ringes 41 eingesetzt, der seinerseits eine nicht gezeigte Strom führende Leitung umgibt, so dass über die Messung des Magnetflusses im Magnetfeldspalt 12 der Strom durch den Leiter, der von dem weichmagnetischen Material 41 umgeben ist, erfasst werden kann.

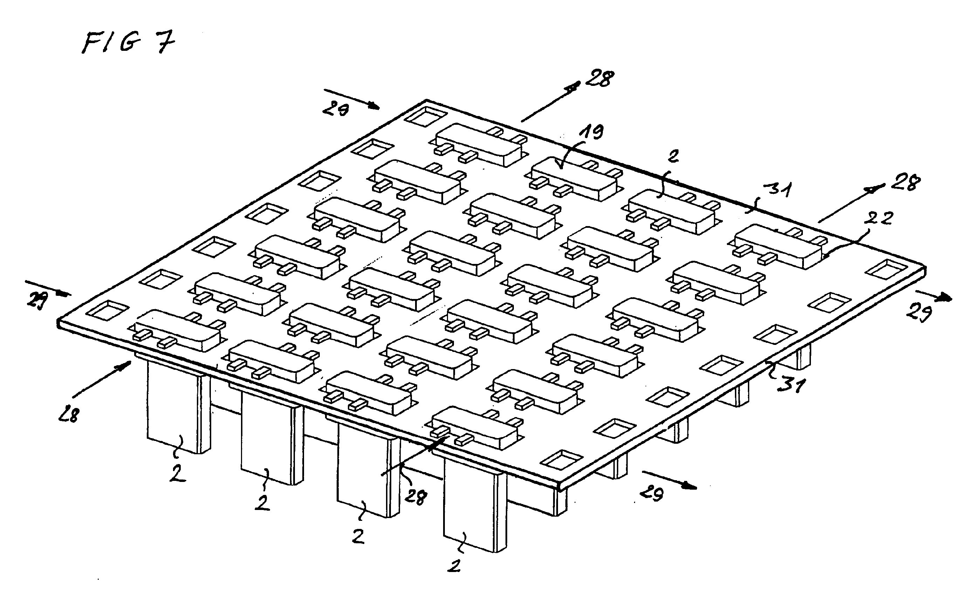

Figur 7 zeigt eine schematische perspektivische Ansicht eines Tabletts 31 mit positionierten Magnetfeldsensoren 1 oder 2 gemäß Figur 2 bzw. Figur 4 zum Zuführen der Magnetfeldsensoren 1 oder 2 in einen Bestückungsautomaten. Auf einem derartigen Tablett 31 sind die Magnetfeldsensoren 2 in Zeilen 29 und Spalten 28 angeordnet und hängen in diesem Beispiel in Öffnungen 22, aus denen sie mit Hilfe jeweils einer Vakuumpinzette herausgehoben werden können, wobei die Vakuumpinzetten auf den geglätteten Oberflächenbereichen 19 der Magnetfeldsensoren 2 der vorliegenden Erfindung gesetzt werden können und dem Bestückungsautomaten zugeführt werden können.

Figur 8 zeigt wie bereits einleitend erläutert eine schematische perspektivische Ansicht eines ersten Magnetfeldsensors 3 gemäß dem Stand der Technik. Figur 9 zeigt einen schematischen Querschnitt durch eine Magnetfeldmessvorrichtung 40 mit dem Magnetfeldsensor 3 gemäß Figur 8. Figur 10 zeigt außerdem einen schematischen Querschnitt durch eine Magnetfeldmessvorrichtung 50 mit einem oberflächenmontierbaren weiteren Magnetfeldsensor gemäß dem Stand der Technik. Dazu wird auf die einleitende Beschreibung zum Stand der Technik hingewiesen.

## Patentansprüche

1. Oberflächenmontierbarer Magnetfeldsensor (1) mit einem Halbleiterchip (4) auf einem Flachleitersubstrat (5) und mit mindestens drei Flachleiterelektroden (6 bis 9), die aus einer Kunststoffgehäuseseite (10) herausragen, wobei der Halbleiterchip (4) und das Flachleitersubstrat (5) in das Kunststoffgehäuse (11) eingebettet sind, und wobei das Kunststoffgehäuse (11) mit dem eingebetteten Halbleiterchip (4) in einen Magnetfeldspalt (12) unter Herausragen der Flachleiterelektroden (6 bis 9) einsetzbar ist und wobei die Flachleiterelektroden (6 bis 9) beabstandet von der Kunststoffgehäuseseite (10) Abkantungen (13 bis 16) aufweisen, die auf einer Schaltungsplatine oberflächenmontierbar sind,
**dadurch gekennzeichnet, dass**
die Abkantungen (13 bis 16) der Flachleiterelektroden (6 bis 9) in einem Kunststoffhalter (17) angeordnet sind, welcher an die Abkantungen (13 bis 16) der Flachleiterelektroden (6 bis 9) angespritzt ist.

2. Magnetfeldsensor nach Anspruch 1,
**dadurch gekennzeichnet, dass**
die Abkantungen (13 bis 16) in unterschiedlichen Richtungen (A, B) aus dem Kunststoffhalter (17) herausragen.

3. Magnetfeldsensor nach Anspruch 1 oder Anspruch 2,
**dadurch gekennzeichnet, dass**
der Kunststoffhalter (17) ein Kodierelement (18) aufweist.

4. Magnetfeldsensor nach einem der Ansprüche 2 bis 3,
**dadurch gekennzeichnet, dass**
der Kunststoffhalter (17) einen geglätteten Oberflächenbereich (19) aufweist, der für ein Aufnehmen des Magnetfeldsensors (1) mittels einer Saugpipette geglättet ist.

5. Magnetfeldsensor nach Anspruch 4,
**dadurch gekennzeichnet, dass**
der Kunststoffhalter (17) eine seitlich zu dem Oberflächenbereich (19) angebrachte Schürze (20) aufweist, aus der die Abkantungen (13 bis 16) der Flachleiterelektroden (6 bis 9) herausragen, und wobei die Schürze (20) einen Wulst (21) als Kodierelement (18) aufweist.

6. Magnetfeldsensor nach einem der Ansprüche 3 bis 5,
**dadurch gekennzeichnet, dass**
der Kunststoffhalter (17) mit dem Kodierelement (18) in einer angepassten Öffnung (22) unter einem Winkel (α) zu einer Oberseite (23) einer Schaltungsplatine (24) angeordnet ist, und wobei das Kunststoffgehäuse (11) unter diesem Winkel (α) von der Oberseite (23) der Schaltungsplatine (24) absteht.

7. Magnetfeldsensor nach einem der vorhergehenden Ansprüche,
**dadurch gekennzeichnet, dass**
der Magnetfeldsensor (1) ein Hallsensor ist, der mindestens drei Flachleiterelektroden (6 bis 9) mit Abkantungen (13 bis 16) aufweist.

8. Magnetfeldsensor nach einem der vorhergehenden Ansprüche,
**dadurch gekennzeichnet, dass**
der Kunststoffhalter (17) und das Kunststoffgehäuse (11) eine einstückige Umhüllung (25) der Flachleiterelektroden (6 bis 9), des Halbleiterchips (4) und des Flachleitersubstrats (5) aufweisen, und wobei aus der einstückigen Umhüllung (25) die Abkantungen (13 bis 16) der Flachleiterelektroden (6 bis 9) oberflächenmontierbar herausragen.

9. Magnetfeldmessvorrichtung mit einem Magnetfeldsensor (1) nach einem der vorhergehenden Ansprüche, wobei die Magnetfeldmessvorrichtung (30) eine mit aktiven und/oder passiven Bauelementen bestückte Seite einer Schaltungsplatine (24) aufweist, in die eine Öffnung (22) eingearbeitet ist, in der passgenau und ausgerichtet der Magnetfeldsensor (1) mit dem Kunststoffhalter (17) eingesteckt ist, und wobei die Abkantungen (13 bis 16) der Flachleiterelektroden (6 bis 9) auf der Bestückungsseite oberflächenmontiert sind und das Kunststoffgehäuse (11) mit dem Halbleiterchip (4) und dem Flachleitersubstrat (5) aus der Unterseite (26) heraus- und in den Magnetfeldspalt (12) hineinragen.

10. Verfahren zur Herstellung und Bestückung einer Schaltungsplatine (24) mit einem Magnetfeldsensor (1), das folgende Verfahrensschritte aufweist:
- Abkanten von Flachleiterelektroden (6 bis 9) des Magnetfeldsensors (1), die aus einer Kunststoffgehäuseseite (10) herausragen;
- Spritzgießen eines Kunststoffhalters (17) an die abgekanteten Flachleiterelektroden (6 bis 9);
- Herstellen einer Schaltungsplatine (24), die über einem Magnetfeldspalt (12) angeordnet werden kann;
- Einbringen einer Öffnung (22) in die Schaltungsplatine (24), die in Kontur und Größe einer Schürze (20) mit kodierelement (18) des Magnetfeldsensors (1) angepasst wird;
- Anbringen von Kontaktflächen (27) auf der Schaltungsplatine (24) zur Oberflächenmontage der Abkantungen (13 bis 16) der Flachleiterelektroden (6 bis 9);
- Einbringen des Magnetfeldsensors (1) in die Öffnung (22) und Oberflächenmontage des Magnetfeldsensors (1) unter stoffschlüssigem Verbinden der Abkantungen (13 bis 16) der Flachleiterelektroden (6 bis 9) auf der Oberseite (23) der Schaltungsplatine (24) mit den Kontaktflächen (27), derart, dass das Kunststoffgehäuse (11) mit einem Halbleiter-Sensorchip (4) von der Unterseite (26) der Schaltungsplatine (24) beabstandet angeordnet ist.

11. Verfahren nach Anspruch 10,
**dadurch gekennzeichnet, dass**
das Einbringen des Magnetfeldsensors (1) in die Öffnung (22) der Schaltungsplatine (24) unter Einsatz eines Bestückungsautomaten erfolgt, wobei mehrere Magnetfeldsensoren (1) auf einem Tablett (31) in Zeilen (29) und Spalten (28) angeordnet und dem Bestückungsautomaten zugeführt werden.

12. Verfahren nach Anspruch 11,
**dadurch gekennzeichnet, dass**
die Magnetfeldsensoren (1) mittels Ansaugen eines geglätteten Oberflächenbereichs (19) des Kunststoffhalters (17) durch eine Vakuumpipette von dem Tablett abgehoben und einer Bestückungsposition auf einer Schaltungsplatine (24) zugeführt werden.

## Claims

1. Surface-mountable magnetic field sensor (1) comprising a semiconductor chip (4) on a flat-conductor substrate (5) and comprising at least three flat-conductor electrodes (6 to 9) protruding from a plastic housing side (10), wherein the semiconductor chip (4) and the flat-conductor substrate (5) are embedded into the plastic housing (11), and wherein the plastic housing (11) can be inserted with the embedded semiconductor chip (4) into a magnetic field gap (12), with the flat-conductor electrodes (6 to 9) protruding, and wherein the flat-conductor electrodes (6 to 9) have bent portions (13 to 16) at a distance from the plastic housing side (10), said bent portions being surface-mountable on a circuit board,
**characterized in that**
the bent portions (13 to 16) of the flat-conductor electrodes (6 to 9) are arranged in a plastic holder (17), which is injection-molded onto the bent portions (13 to 16) of the flat-conductor electrodes (6 to 9).

2. Magnetic field sensor according to Claim 1,
**characterized in that**
the bent portions (13 to 16) protrude from the plastic holder (17) in different directions (A, B).

3. Magnetic field sensor according to Claim 1 or Claim 2,
**characterized in that**
the plastic holder (17) has a coding element (18).

4. Magnetic field sensor according to any of Claims 2 to 3,
**characterized in that**
the plastic holder (17) has a smoothed surface region (19), which is smoothed for picking up the magnetic field sensor (1) by means of a suction pipette.

5. Magnetic field sensor according to Claim 4,
**characterized in that**
the plastic holder (17) has an apron (20) fitted laterally with respect to the surface region (19), from which apron the bent portions (13 to 16) of the flat-conductor electrodes (6 to 9) protrude, and wherein the apron (20) has a bead (21) as coding element (18).

6. Magnetic field sensor according to any of Claims 3 to 5,
**characterized in that**
the plastic holder (17) with the coding element (18) is arranged in a matched opening (22) at an angle (α) with respect to a top side (23) of a circuit board (24), and wherein the plastic housing (11) projects at said angle (α) from the top side (23) of the circuit board (24).

7. Magnetic field sensor according to any of the preceding claims,
**characterized in that**
the magnetic field sensor (1) is a Hall sensor having at least three flat-conductor electrodes (6 to 9) having bent portions (13 to 16).

8. Magnetic field sensor according to any of the preceding claims,
**characterized in that**
the plastic holder (17) and the plastic housing (11) have an integral encapsulation (25) of the flat-conductor electrodes (6 to 9), of the semiconductor chip (4) and of the flat-conductor substrate (5), and wherein the bent portions (13 to 16) of the flat-conductor electrodes (6 to 9) protrude from the integral encapsulation (25) in a surface-mountable fashion.

9. Magnetic field measuring device comprising a magnetic field sensor (1) according to any of the preceding claims, wherein the magnetic field measuring device (30) has a side - populated with active and/or passive components - of a circuit board (24), into which is incorporated an opening (22), in which the magnetic field sensor (1) with the plastic holder (17) is inserted with an accurate fit and in an aligned manner, and wherein the bent portions (13 to 16) of the flat-conductor electrodes (6 to 9) are surface-mounted on the placement side and the plastic housing (11) with the semiconductor chip (4) and the flat-conductor substrate (5) protrude from the underside (26) and into the magnetic field gap (12).

10. Method for producing and populating a circuit board (24) with a magnetic field sensor (1), comprising the following method steps:
- bending flat-conductor electrodes (6 to 9) of the magnetic field sensor (1) which protrude from a plastic housing side (10);
- injection-molding a plastic holder (17) onto the bent flat-conductor electrodes (6 to 9);
- producing a circuit board (24), which can be arranged above a magnetic field gap (12);
- introducing an opening (22) into the circuit board (24), which is matched in terms of contour and size to an apron (20) with a coding element (18) of the magnetic field sensor (1);
- fitting contact areas (27) on the circuit board (24) for the surface mounting of the bent portions (13 to 16) of the flat-conductor electrodes (6 to 9);
- introducing the magnetic field sensor (1) into the opening (22) and surface mounting of the magnetic field sensor (1) with cohesive connection of the bent portions (13 to 16) of the flat-conductor electrodes (6 to 9) on the top side (23) of the circuit board (24) with the contact areas (27), in such a way that the plastic housing (11) is arranged with a semiconductor sensor chip (4) at a distance from the underside (26) of the circuit board (24).

11. Method according to Claim 10,
**characterized in that**
the magnetic field sensor (1) is introduced into the opening (22) in the circuit board (24) using an automatic placement machine, wherein a plurality of magnetic field sensors (1) are arranged on a tray (31) in rows (29) and columns (28) and are fed to the automatic placement machine.

12. Method according to Claim 11,
**characterized in that**
the magnetic field sensors (1) are lifted from the tray by means of a vacuum pipette sucking up a smoothed surface region (19) of the plastic holder (17) and are fed to a placement position on a circuit board (24).

## Revendications

1. Capteur de champ magnétique (1) montable en surface avec une puce semi-conductrice (4) sur un substrat conducteur plat (5) et avec au moins trois électrodes conductrices plates (6 à 9) qui dépassent d'un côté de boîtier en matière plastique (10), dans lequel la puce semi-conductrice (4) et le substrat conducteur plat (5) sont encastrés dans le boîtier en matière plastique (11), et dans lequel le boîtier en matière plastique (11) peut être incorporé avec la puce semi-conductrice (4) dans un entrefer de champ magnétique (12) à condition de laisser dépasser les électrodes conductrices plates (6 à 9), dans lequel les électrodes conductrices plates (6 à 9) présentent, à distance du côté du boîtier en matière plastique (10), des rebords (13à 16) qui peuvent être montés en surface sur une platine de circuits imprimés,
**caractérisé en ce que** les rebords (13 à 16) des électrodes conductrices plates (6 à 9) sont agencés dans un support en matière plastique (17), qui est injecté au niveau des rebords (13 à 16) des électrodes conductrices plates (6 à 9).

2. Capteur de champ magnétique selon la revendication 1, **caractérisé en ce que** les rebords (13 à 16) dépassent du support en matière plastique (17) dans différentes directions (A, B).

3. Capteur de champ magnétique selon la revendication 1 ou la revendication 2, **caractérisé en ce que** le support en matière plastique (17) présente un élément de codage (18).

4. Capteur de champ magnétique selon l'une des revendications 2 à 3, **caractérisé en ce que** le support en matière plastique (17) présente une zone de surface (19) lisse qui a été lissée afin de pouvoir prendre le capteur de champ magnétique (1) à l'aide d'une pipette d'aspiration.

5. Capteur de champ magnétique selon la revendication 4, **caractérisé en ce que** le support en matière plastique (17) présente un tablier (20) placé latéralement par rapport à la zone de surface (19) de laquelle dépassent les rebords (13 à 16) des électrodes conductrices plates (6 à 9), dans lequel le tablier (20) présente un renflement (21) en tant qu'élément de codage (18).

6. Capteur de champ magnétique selon l'une des revendications 3 à 5, **caractérisé en ce que** le support en matière plastique (17) est agencé avec l'élément de codage (18) dans une ouverture (22) adaptée et en formant un angle (α) par rapport à un côté supérieur (23) d'une platine de circuits imprimés (24), dans lequel le boîtier en matière plastique (11) s'écarte, avec cet angle (α), du côté supérieur (23) de la platine de circuits imprimés (24).

7. Capteur de champ magnétique selon l'une des revendications précédentes, **caractérisé en ce que** le capteur de champ magnétique (1) est un capteur à effet Hall qui présente au moins trois électrodes conductrices plates (6 à 9) avec des rebords (13 à 16).

8. Capteur de champ magnétique selon l'une des revendications précédentes, **caractérisé en ce que** le support en matière plastique (17) et le boîtier en matière plastique (11) présentent une gaine monobloc (25) pour les électrodes conductrices plates (6 à 9), la puce semi-conductrice (4) et le substrat conducteur plat (5), dans lequel les rebords (13 à 16) des électrodes conductrices plates (6 à 9) dépassent de la gaine monobloc (25) de façon à pouvoir être montés en surface.

9. Dispositif de mesure de champ magnétique avec un capteur de champ magnétique (1) selon l'une des revendications précédentes, dans lequel le dispositif de mesure de champ magnétique (30) présente un côté d'une platine de circuits imprimés (24) équipé de composants actifs et/ou passifs, dans lequel est insérée une ouverture (22) dans laquelle le capteur de champ magnétique (1) est incorporé avec le support en matière plastique (17), de manière alignée et parfaitement ajustée, et dans lequel les rebords (13 à 16) des électrodes conductrices plates (6 à 9) sont montés en surface sur le côté équipé de composants, et le boîtier en matière plastique (11) dépasse, avec la puce semi-conductrice (4) et le substrat conducteur plat (5), à partir du côté inférieur (26) et s'enfonce dans l'entrefer du champ magnétique (12).

10. Procédé de fabrication et d'équipement avec des composants d'une platine de circuits imprimés (24) avec un capteur de champ magnétique (1), qui présente les étapes de procédé suivantes :
- pliage d'électrodes conductrices plates (6 à 9) du capteur de champ magnétique (1) qui dépassent d'un côté du boîtier en matière plastique (10) ;
- injection d'un support en matière plastique (17) sur les électrodes conductrices plates (6 à 9) repliées ;
- réalisation d'une platine de circuits imprimés (24) qui peut être agencée au-dessus d'un entrefer de champ magnétique (12) ;
- insertion d'une ouverture (22) dans la platine de circuits imprimés (24), qui, pour le contour et la taille, est adaptée à un tablier (20) avec un élément de codage (18) du capteur de champ magnétique (1) ;
- placement de surfaces de contact (27) sur la platine de circuits imprimés (24) pour le montage en surface des rebords (13 à 16) des électrodes conductrices plates (6 à 9) ;
- insertion du capteur de champ magnétique (1) dans l'ouverture (22) et montage en surface du capteur de champ magnétique (1) via une liaison de matière des rebords (13 à 16) des électrodes conductrices plates (6 à 9) sur le côté supérieur (23) de la platine de circuits imprimés (24) avec les surfaces de contact (27), de telle sorte que le boîtier en matière plastique (11) avec une puce semi-conductrice (4) est agencé à distance du côté inférieur (26) de la platine de circuits imprimés (24).

11. Procédé selon la revendication 10, **caractérisé en ce que** l'insertion du capteur de champ magnétique (1) dans l'ouverture (22) de la platine de circuits imprimés (24) s'effectue à l'aide d'un automate d'équipement avec des composants, dans lequel plusieurs capteurs de champ magnétique (1) sont agencés sur une tablette (31) en lignes (29) et en colonnes (28) et amenés vers l'automate d'équipement avec des composants.

12. Procédé selon la revendication 11, **caractérisé en ce que** les capteurs de champ magnétique (1) sont soulevés de la tablette à l'aide d'une pipette à vide et par aspiration d'une zone de surface (19) lisse du support en matière plastique (17), et amenés dans une position d'équipement avec des composants sur une platine de circuits imprimés (24).
